Europäisches Patentamt

European Patent Office

Office européen des brevets

(19)

(11) Veröffentlichungsnummer: **0 245 761**
**B1**

(12) **EUROPÄISCHE PATENTSCHRIFT**

(45) Veröffentlichungstag der Patentschrift: **03.10.90**

(51) Int. Cl.⁵: **F 02 P 7/02**, **H 05 K 9/00**

(21) Anmeldenummer: **87106545.4**

(22) Anmeldetag: **06.05.87**

(54) Manschettenförmige Entstörabschmirmung für Zündverteiler an Brennkraftmaschinen.

(30) Priorität: **15.05.86 DE 3616471**

(43) Veröffentlichungstag der Anmeldung:
**19.11.87 Patentblatt 87/47**

(45) Bekanntmachung des Hinweises auf die
Patenterteilung:
**03.10.90 Patentblatt 90/40**

(84) Benannte Vertragsstaaten:
**DE ES FR GB IT SE**

(56) Entgegenhaltungen:
EP-A-0 075 263
FR-A-1 534 024
FR-A-2 222 882
GB-A- 573 660
GB-A-2 151 413
US-A-1 987 755
US-A-3 838 207

(73) Patentinhaber: **Adam Opel Aktiengesellschaft**
**Bahnhofsplatz 1 Postfach 17 10**
**D-6090 Rüsselsheim (DE)**
(84) **DE ES FR GB**

(73) Patentinhaber: **General Motors Espana, S.A.**
**Poligono Entrerrios**
**Figueruelas (Zaragoza) (ES)**
(84) **ES**

(72) Erfinder: **Kunz, Werner**
**Bahnweg 37**
**D-6093 Flörsheim (DE)**
Erfinder: **Joisten, Jan, Ing. (grad.)**
**Steinstrasse 2**
**D-6090 Rüsselsheim (DE)**
Erfinder: **Fückel, Horst, Ing. (grad.)**
**Heinrich-Kaul-Platz 1**
**D-6085 Nauheim (DE)**

(74) Vertreter: **Spitzl, Karl**
**c/o Adam Opel AG Patentabteilung**
**Bahnhofsplatz 1 Postfach 1710**
**D-6090 Rüsselsheim (DE)**

Courier Press, Leamington Spa, England.

**Beschreibung**

Die Erfindung betrifft eine Entstörabschirmung für Zündverteiler an Brennkraftmaschinen, bestehend aus einer biegsamen, elektrisch leitenden Manschette mit wenigstens einer Lage Trägermaterial, die faltbar ist und deren seitliche Randflächen Verbindungsteile entweisen und durch diese lösbar miteinander verbindbar sind, wobei im montierten Zustand die seitlichen Randflächen aneinanderliegen und die Manschette den Zündverteiler und seine Leitungen im Mündungsbereich umschließt.

Die Manschette einer aus der EP—A1—75 263 bekannten Entstörabschirmung der eingangs genannten Art besteht insgesamt aus einem elektrisch leitenden Silikonelastomer und ist entsprechend materialaufwendig (vgl. auch DE—GM 81 27 135). Um der biegsamen, faltbaren Manschette neben der hohen elektrischen Leitfähigkeit zusätzlich die erforderliche Festigkeit zu verleihen, welche insbesondere auch an den seitlichen, die Befestigungsmittel aufweisenden Randflächen gegeben sein muß, ist die Manschette zwangsläufig mit einer entsprechenden Stärke auszubilden, was zu relativ hohen Materialkosten führt.

In der GB—A—573 660 ist eine Abschirmung beschrieben, die aus niederohmigem Gummimaterial besteht und bei fehlender Isolierung des abzuschirmenden Teils zusätzlich eine Innenschicht aus normalem Gummi aufweisen kann, um die fehlende Isolierung sicherzustellen. Bei einem bereits isolierten abzuschirmenden Teil kann die Abschirmung vollständig aus niederohmigem Gummimaterial bestehen. In beiden Fällen bildet demnach das niederohmige Gummimaterial selbst gleichzeitig auch den Träger für die Abschirmung.

Bei einem aus der GB—A—2 151 413 bekannten Elektromotor besteht das Abschirmgehäuse abgesehen von einem stirnseitigen, Kontakte wie Bürstenelemente tragenden und damit zwangsläufig aus isolierendem Material herzustellenden Deckel aus Metall. Auf dem nicht beigsamen und nicht faltbaren, in erster Linie zur gegenseitigen Isolierung mehrerer Kontakte und dergleichen dienenden Deckel aus isolierenden Material ist auf der Außenfläche ein dünner, entsprechende Ausnehmungen für die Kontakte und dergleichen aufweisender Metallfilm vorgesehen.

In der US—A—1 987 755 ist eine Abschirmung beschrieben, bei welcher zur Herstellung der erforderlichen Festigkeit die elektrisch leitende Schicht als Metalldrahtgeflecht ausgebildet ist. Die erforderliche Festigkeit der Abschirmung wird auch in diesem Falle wiederum durch die elektrisch leitende Schicht selbst bewerkstelligt, während der Gummimantel lediglich zu Isolationszwecken vorgesehen ist.

Ziel der Erfindung ist es, eine aus einer biegsamen, faltbaren und an den seitlichen Randflächen schließbaren Manschette bestehende Entstörabschirmung der eingangs genannten Art zu schaffen, die einfach und kostengünstig herstellbar und damit für eine Massenfertigung geeignet ist sowie problemlos handhabbar ist, und die dennoch sowohl die gewünschte hohe elektrische Leitfähigkeit als auch die im Hinblick auf die auftretenden besonderen Beanspruchungen bei einer solchen Manschette erforderliche hohe Festigkeit aufweist.

Die Aufgabe wird nach der Erfindung dadurch gelöst, daß das Trägermaterial der Manschette elektrisch nicht leitfähig ist und aus Gewebe, Kunststoffolie oder dergleichen besteht, daß an der Lage bzw. zwischen den Lagen Trägermaterial eine separate elektrisch leitfähige Auflage oder Einlage fixiert ist, und daß das Trägermaterial und die Auflage bzw. Einlage punktweise mit Befestigungselementen zusammengespannt sind, die zugleich ein Verbindungteil der lösbaren Manschettenrandverbindung tragen.

Aufgrund dieser Ausbildung erfolgt eine klare Trennung zwischen der Gewährleistung der elektrischen Leitfähigkeit einerseits und der Trägerfunktion zur Sicherstellung der erforderlichen Festigkeit andererseits, wobei die Befestigungselemente in konstruktiv unaufwendiger Weise eine Doppelfunktion übernehmen. Infolge der erfindungsgemäßen Funktionstrennung zwischen Träger und elektrischer Leitfähigkeit ist die Herstellung der gesamten Entstörabschirmung wesentlich vereinfacht ohne daß hierbei irgendwelche Einbußen im Hinblick auf die elektrische Leitfähigkeit und die Festigkeit in Kauf genommen werden müßten. Wider Erwarten reduziert der mehrschichtige Aufbau die zu erwartenden Herstellungskosten, da erfindungsgemäß das Trägermaterial völlig unabhängig von der leitfähigen Auflage bzw. Einlage ausgelegt werden kann, d.h. im Hinblick auf eine möglichst hohe Festigkeit gewählt wird, während für die leitfähige Auflage bzw. Einlage billigere Materialien mit geringerer Festigkeit, wie beispielsweise eine einfache Metallfolie verwendet werden können. Die Lage Trägermaterial kann insbesondere auch im Hinblick auf einen möglichst guten mechanischen Schutz und/oder Korrosionsschutz, insbesondere Wasserabschirmung, ausgewählt werden.

Bei einem zweischichtigen Aufbau der Manschette aus einer Lage Trägermaterial mit einer elektrisch leitfähigen Auflage oder Beschichtung liegt das Trägermaterial im gefalteten Zustand der Manschette vorzugsweise außen.

Gemäß einer anderen vorteilhaften Ausführungsvariante ist vorgesehen, daß die Manschette dreischichtig aus zwei Lagen Trägermaterial und einer dazwischenliegenden, elektrisch leitfähigen Einlage oder Beschichtung aufgebaut ist.

Hierbei sind die Lagen Trägermaterial am Rand vorzugsweise dauerhaft miteinander verbunden, insbesondere vernäht oder verklebt.

Als Manschettenrandverbindung ist vorteilhafterweise eine Druckknopfanordnung vorgesehen, wobei die von den Befestigungselementen getragenen Verbindungsteile durch den Kopf und die zugehörige Aufnahmebuchse de Druckknopfanordnung gebildet sind. Die Befestigungselemente übernehmen hierbei in besonders vorteilhafter Weise die bereits erwähnte Doppelfunktion. Grundsätzlich können am Manschettenrand anstelle einer Druckknopfverbindung jedoch auch andere Verbindungsformen, insbesondere ein Klettverschluß, vorgesehen sein.

Zweckmäßigerweise sind die Befestigungselemente aus zwei Halbteilen aufgebaut, die je einen tellerförmigen Anlageabschnitt aufweisen und mittels eines die Manschette durchstoßenden Schaftes miteinander verrastbar sind. Hierbei kann der Schaft an dem Anlageabschnitt des einen Halbteils angeordnet sein und in eine mit dem anderen Halbteil verbundene Steckbuchse eingreifen.

Die Befestigungselemente bestehen vorzugsweise aus Kunststoff.

Die Manschette kann zweckmäßigerweise mit einem Masseband versehen sein, das mit der elektrisch leitenden Auflage, Einlage oder Beschichtung in Berührung steht und mittels eines Befestigungselements an der Manschette anbringbar ist.

Auch dieses Masseband kann mit den erwähnten, eine Druckknopfanordnung bildenden Befestigungselementen belegt und zu einem Ring schließbar sein.

Das Masseband kann insbesondere aus einem elektrisch leitenden Kunststoff oder elektrisch leitenden Elastomer, beispielsweise einem Silikonelastomer bestehen. Es sollte dann insgesamt ein hinreichendes Maß an Elastizität aufweisen, damit es sich um ein elektrisch auf Masse liegendes Motor- oder Karosserieteil herumspannen läßt, wodurch man eine flächige Anlage und einen geringen Übergangswiderstand erhält.

Das Masseband kann jedoch auch aus einem Streifen Trägermaterial mit einer elektrisch leitfähigen Auflage oder Beschichtung bestehen, wobei die Auflage zweckmäßigerweise punktweise mit dem Trägermaterial verbunden sein kann, vorzugsweise mit einem Befestigungselement an nur einem einzigen Punkt. Man trennt so in vorteilhafter Weise die Funktion eines elektrisch gut leitenden Kontaktstreifens und eines zum Aufspannen des Kontaktstreifens dienenden elastischen Bandes.

Das für die Manschette selbst verwendete Trägermaterial und die entsprechende elektrisch leitende Auflage, Einlage oder Beschichtung der erfindungsgemäßen Manschette sind dagegen zwar notwendigerweise flexibel, also biegsam, aber nicht unbeding elastisch.

Weitere vorteilhafte Ausführungsvarianten der Erfindung sind in den Unteransprüchen angegeben.

(Fortsetzung handschriftlich korrigierte Figurenbeschreibung.)

Die Erfindung wird im folgenden anhand von in den Zeichnungen dargestellten Ausführungsbeispielen näher erläutert. Teilweise schematisch zeigen:

Fig. 1 eine Draufsicht auf eine erste manschettenförmige Enstörabschirmung für Zündverteiler im aufgefalteten Zustand;

Fig. 2 eine Bauzeichnung dieser Entstörabschirmung mit Längsschnitt durch ein kombiniertes Befestigungs- und Druckknopfelement;

Fig. 3 eine Draufsicht auf eine zweite manschettenförmige Entstörabschirmung für Zündverteiler im aufgefalteten Zustand;

Fig. 4 einen Schnitt durch die Enstörabschirmung nach IV—IV von Fig. 3.

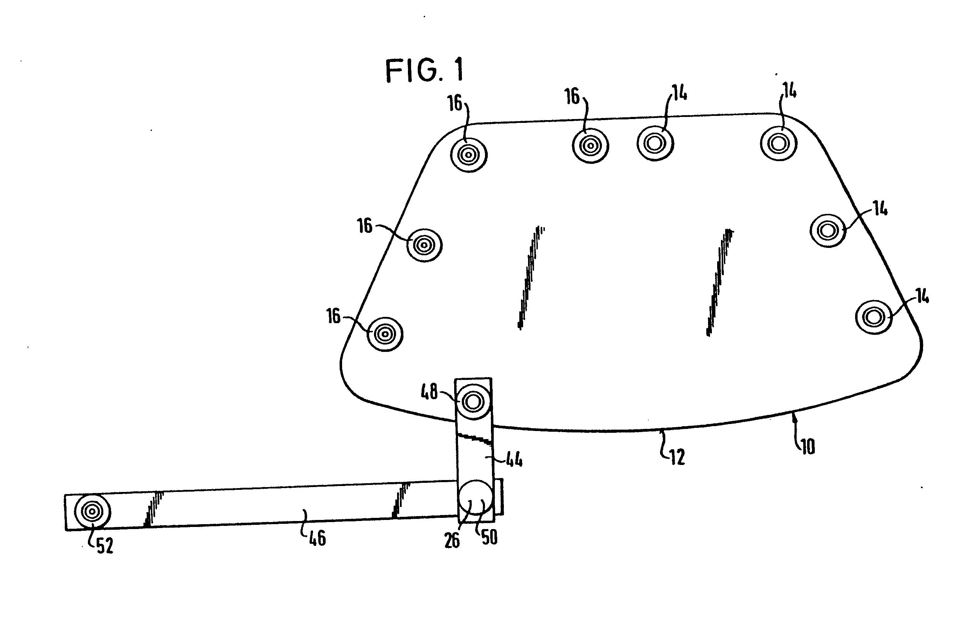

Die Manschette 10 der in Fig. 1 gezeigten Entstörabschirmung für Zündverteiler hat im aufgefalteten Zustand einen im wesentlichen trapezförmigen Gerundriß. Der Rand 12 der Manschette 10 an der Trapezbasis ist konvex nach außen gekrümmt. Die Ecken der Manschette 10 sind gerundet.

Die Manschette 10 läßt sich entlang einer Quermittelebene falten, wobei ihre Halbteile im wesentlichen miteinander zur Deckung kommen, und an ihrem Rand mit Druckknöpfen schließen. Kopfteile 14 und zugehörige Buchsenteile 16 der Druckknopfanordnung bilden somit Verbindungsteile einer lösbaren Manschettenrandverbindung. Drei Druckknöpfe befinden sich im wesentlichen gleichmäßig über deren Länge verteilt an den Schenkeln des Trapezes, und ein Druckknopf ist im Mittelbereich der kürzeren Grundlinie angeordnet.

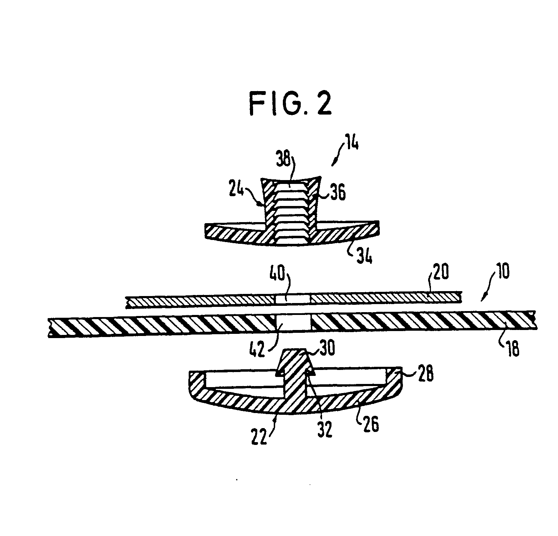

Wie Fig. 2 zu entnehmen, ist die Manschette 10 zweischichtig aufgebaut. Ihre im zusammengeknöpften Zustand außen liegende Schicht bzw. Lage wird von einem Trägermaterial 18 gebildet, das in aller Regel nicht elektrisch leitend ist. Bei diesem Trägermaterial 18 kann es sich beispielsweise um ein Gewebe oder eine Folie, insbesondere eine Kunststoffolie, handeln. Das Trägermaterial 18 kann flüssigkeitsundurchlässig sein, um im montierten Zustand der Manschette 10 einen Wasserzutritt an den Zündverteiler zu verhindern. Ein Gewebe kann hierzu in geeigneter Weise imprägniert sein. In jedem Fall hat das Trägermaterial 18 die Funktion, eine innere, elektrisch leitfähige Auflage 20 der Manschette 10 abzudekken und mechanisch zu schutzen.

Die elektrisch leitfähige Auflage 20 besteht gemäß Fig. 2 aus einer Metallfolie, die ein von dem Trägermaterial 18 separates Teil darstellt und im wesentlichen gleichen Grundriß gemäß Fig. 1 hat. Als Material der Folie kommen insbesondere Aluminium, Zinn, Kupfer oder Legierungen dieser Metalle in Betracht. Die Folie kann eine dünne, insbesondere aufgedampfte oder galvanisch aufgebrachte Silberschicht aufweisen, um eine hohe Oberflächenleitfähigkeit zu gewährleisten.

Die Lage Trägermaterial 18 und die durch eine Metallfolie gebildete elektrisch leitfähige Auflage 20 werden gemäß Fig. 2 mit Befestigungselementen zusammengespannt, an die zugleich das Kopfteil 14 bzw. Buchsenteil 16 der Druckknopfanordnung einstückig angeformt ist. Die Befestigungselemente bestehen aus zwei Halbteilen 22, 24. Das an der Außenseite der Manschette 10 zu liegen kommende Halbteil 22 hat einen im Grundriß kreisrunden, tellerförmig gewölbten Anlageabschnitt 26 mit einem axial hochstehenden Rand 28. Mittig im Inneren des tellerförmigen Anlageabschnitts 26 befindet sich ein einstückig daran angeformter, in Axialrichtung abstehender schaft 30, der als Verankerungsstift dient. Dieser Schaft 30 weist Rastmittel auf, die in Fig. 2 durch einen konischen Kopf repräsentiert sind, der sich vom freien Ende des Schaftes 30 zum Boden des tellerförmigen Anlageabschnitts 26 hin erweitert und in einer Stufe 32 auf das Durchmessermaß des Schaftes 30 zurückspringt. Das innen an der Manschette 10 zu liegen kommende Halbteil 24 hat einen im Grundriß ebenfalls kreisrunden, tellerförmigen Anlageabschnitt 34, der wie der tellerförmige Anlageabschnitt 26 des äußeren Halbteils 22 gewölbt ist und in dessen Telleröffnung paßt. An den Anlageabschnitt 34 ist in mittiger Anordnung, eine Steckbuchse 36 angeformt, die eine den tellerförmigen Anlageabschnitt 34 durchstoßende Axialbohrung 38 hat. Die Axialbohrung 38 weist auf ihrem Innenmantel Rastmittel auf, die mit denen an dem Schaft 30 zusammenarbeiten, beispielsweise in Gestalt einer Verzahnung mit mehreren in Axialrichtung aufeinanderfolgenden Stufen, an denen der Kopf des Schaftes 30 Halt findet. Die Halbteile 22, 24 der Verbindungselemente bestehen vorzugsweise aus einem elastischen Kunststoff. Ihre Rastverbindung ist bei normalem Krafteinsatz nicht lösbar.

Zur Herstellung der Manschette 10 werden die Lage Trägermaterial 18 und die folienartige Auflage 20 mit den Halbteilen 22, 24 der Befestigungselemente zusammengespannt. Dabei greift der als Verankerungsstifft dienende Schaft 30 durch fluchtende Löcher 40, 42 im Trägermaterial 18 bzw. der Auflage 20 hindurch. Die Halbteile 22, 24 werden zusammengedrückt, wozu eine Zange Verwendung finden kann. Der Kopf des Schaftes 30 kommt dabei je nach Dicke des Manschettenmaterials in einer passenden Rast der Steckbuchse 36 zu liegen.

Wie schon erwähnt, bilden die Befestigungselemente bzw. deren Halbteile 22, 24 zugleich die Druckknopfanordnung zum Schließen der Manschette 10. Hierzu ist das innenliegende Halbteil 24 der Befestigungselemente entweder als Kopfteil 14 oder als Buchsenteil 16 der Druckknopfanordnung ausgebildet. Fig. 2 zeigt ein Kopfteil 14, das durch eine Steckbuchse 36 realisiert ist, die sich zu ihrem freien Ende hin konisch weitet. Das nicht näher dargestellte zugehörige Buchsenteil hat eine entsprechende Öffnung, in die sich die Steckbuchse 36 unter elastischer Deformation einführen läßt. Damit ist dann der Druckknopf geschlossen.

Die elektrisch leitfähige Schicht bzw. Auflage 20 der Manschette 10 muß nicht unbedingt nur an einzelnen Punkten mit der Lage Trägermaterial 18 verbunden sein. Vielmehr ist auch eine flächige, formschlüssige Verbindung möglich, beispielsweise indem man als elektrisch Leitfähige Auflage 20 eine Metallfolie auf das Trägermaterial 18 aufklebt oder aufkaschiert.

Zurückkommend auf Fig. 1, ist mit der erfindungsgemäßen Manschette 10 ein Masseband 44, 46 verbunden, das aus einem kurzen Abschnitt 44, der an der langen Grundseite bzw. am Rand 12 der Manschette 10 ansetzt, und zwar bei Blick auf deren Innenfläche links auf etwa einem Viertel der Grundseitenlänge, und einem langen Abschnitt 46 besteht. Die Erstreckung des Abschnitts 44 ist im wesentlichen senkrecht zur Grundseite bzw. zum Rand 12. Dieser kurze Abschnitt 44 des Massebands 44, 46 steht mit der elektrisch leitfähigen Anlage 20 der Manschette 10 in Anlage. Er ist mit einem Befestigungselement 48 an die Manschette 10 geklemmt, dessen Druckknopfteil ohne Funktion ist. An das freie Ende des kurzen Abschnitts 44 des Massebandes 44, 46 ist mittels eines weiteren Befestigungselements 50 der lange Abschnitt 46 des Massebandes angeklemmt, der mit dem kurzen Abschnitt 44 einen rechten Winkel einschließt. Am freien Ende des Abschnitts 46 ist ein Befestigungselement 52 vorgesehen, dessen Druckknopfteil mit dem des Befestigungselements 50 zusammenwirkt, so daß sich der lange Abschnitt 46 des Massebandes 44, 46 ringformig schließen und zusammeknöpfen läßt. Das Masseband 44, 46 gemäß Fig. 1 ist einlagig ausgebildet. Es besteht vorzugsweise aus einem elektrisch leitfähigen Kunststoff oder Elastomer, beispielsweise einem Silikonelastomer. Zumindest der lange Abschnitt 46 des Massebandes 44, 46 sollte ein gewisses Maß an Elastizität haben, damit er sich um ein elektrisch auf Masse liegendes Karosserieteil spannen läßt.

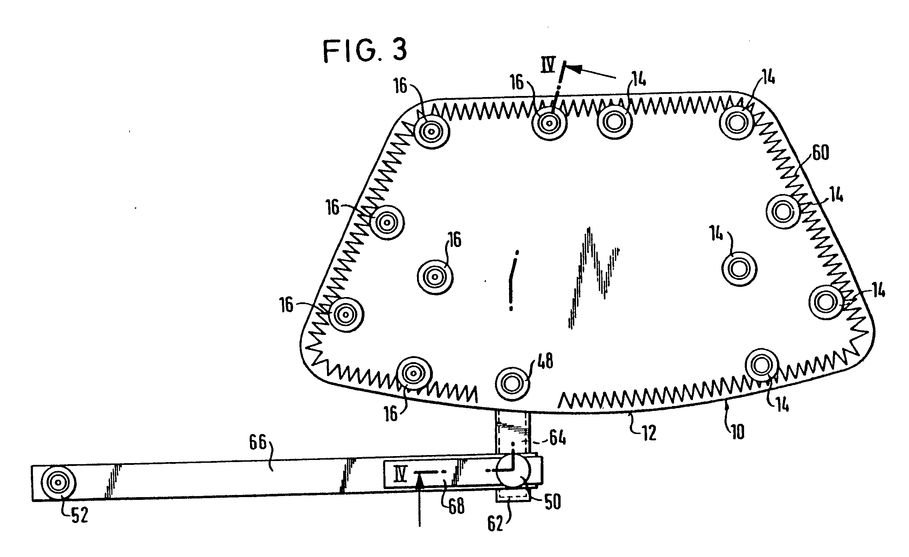

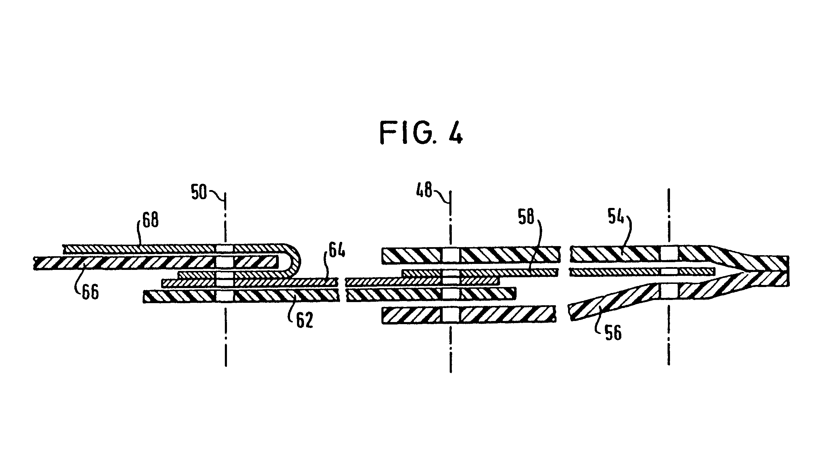

Fig. 3 und Fig. 4 zeigen als weiteres Ausführungsbeispiel eine dreischichtig aufgebaute Entstörmanschette, bei der zwischen zwei Lagen Trägermaterial 54, 56 eine elektrisch leitende Einlage 58 vorgesehen ist. Letztere kann wiederum aus einer Metallfolie bestehen, während für das Trägermaterial ein elektrisch nicht leitendes Gewebe o.ä. in Betracht kommt. Die Lagen Trägermaterial 54, 56 und die Einlage 58 sind mit den schon erwähnten Verbindungsteilen 14, 16 zusammengespannt, die zugleich eine Druckknopfanordnung zum Zusammenhalten der gefalteten Manschette tragen. Verglichen mit Fig. 1, sind zwei zusätsliche Verbindungsteile 14, 16 vorhanden, von denen sich eines an der längeren Trapezgrundlinie der Manschette 10, und das andere im schenkelnahen Bereich auf der Fläche der Manschette 10 befindet. Die Lagen Trägermaterial 54, 56 sind deckungsgleich. Die Einlage 58 hat die gleiche Umrißkontur wie das Trägermaterial 54, 56, ist aber etwas kleiner, so daß das Trägermaterial 54, 56 ringsum über die Einlage 58 übersteht. An diesem überstehenden Rand sind die beiden Lagen Trägermaterial 54, 56 miteinander vernäht. Die Naht 60 läuft ringsum und ist nur am Abgang des Massebands unterbrochen. Statt mit einer Naht 60 können die überstehenden Ränder der Lagen Trägermaterial 54, 56 auch in anderer Weise dauerhaft miteinander verbunden sein, beispielsweise durch Kleben. Die Einlage 58 ist so allseits umhüllt und optimal geschützt.

Die Anordnung des Massebands in Fig. 3 und Fig. 4 entspricht im wesentlichen dem zuvor behandelten Ausführungsbeispiel, nur daß Abgang des Massebands dichter an der Quermittelinie der Manschette 10 liegt. Das Masseband ist aber zweischichtig aufgebaut. Zu dem kurzen Massebandabschnitt gehört somit ein kurzer Streifen Trägermaterial 62 und ein kurzer Streifen Metallfolie bzw. elektrisch leitender Auflage 64. Der lange Massebandabschnitt wird von einem langen Streifen Trägermaterial 66 und einem Ende Metallfolie bzw. elektrisch leitender Auflage 68 gebildet, wobei sich letzteres nur über eine relativ kurzes Stück des langen Massebandabschnitts erstreckt. Die Breite der Metallfolie entspricht jeweils im wesentlichen der der Streifen Trägermaterial 62, 66. Metallfolie bzw. elektrisch leitende Auflage 64, 68 und Trägermaterial 62, 66 sind mit den Befestigungselementen 48, 50, 52 zusammengespannt, die, wie schon mit Bezug auf Fig. 1 beschrieben, zu Befestigung des Massebands an der Manschette und zum ringförmigen Schließen des Massebands dienen.

Die als Metallfolie ausgebildete elektrisch leitende Auflage 64, 68 kommt auf der Innenseite des Massebands zu liegen, auf die in Fig. 3 der Blick gerichtet ist. Fig. 4 zeigt die hierzu erforderliche Führung der Metallfolie an den Befestigungselementen 48, 50. Der kurze Streifen Trägermaterial 62 kommt mit dem kurzen Streifen elektrisch leitfähiger Auflage 64 derart zwischen den Lagen Trägermaterial 54, 56 der Manschette 10 zu liegen, daß dieser aus Metallfolie bestehende kurze Streifen elektrisch leitfähiger Auflage die elektrisch leitende Einlage 58 berührt. Durch Zusammenspannen mit dem Befestigungselement 48 wird so ein Massekontakt hergestellt. Am Befestigungselement 50 umschlingt das aus Metallfolie bestehende Ende den langen Streifen Trägermaterial 66 und kommt mit dem aus Metallfolie bestehenden kurzen Streifen elektrisch leitfähiger Auflage 64 zur Anlage. Die 90°-Abwinkelung des Massebands erscheint in Fig. 4 der Übersichtlichkeit halber nicht. Im Betrieb wird das Ende elektrisch leitender Auflage 68 aus Metallfolie mit dem ringförmig geschlossenen, langen Streifen Trägermaterial 66 gegen ein Motor- oder Karosserieteil des Fahrzeugs gespannt, das elektrisch auf Masse liegt. Der lange Streifen Trägermaterial 66 ist in dem hierzu erforderlichen Maß elastisch. Das Ende elektrisch leitender Auflage 68 aus Metallfolie hat dagegen keine elastischen Eigenschaften. Es ist auch mittels des Befestigungselements 50 an nur einem einzigen Punkt mit dem langen Streifen Trägermaterial 66 verbunden, so daß letzterer problemlos elastisch gedehnt werden kann. Für das Masseband kann dasselbe, aber auch ein anderes Trägermaterial Verwendung finden, als für die übrige Manschette vorgesehen.

Die beschriebene Druckknopfverbindung stellt nur ein Beispiel einer lösbaren Manschettenverbindung dar. Es sind insofern auch andere Verbindungsformen möglich, beispielsweise ein Klettverschluß. Auch ist die Erfindung nicht auf die beschriebene Grundrißform der Manschette 10 beschränkt.

Liste der Bezugszeichen

| | |
|---|---|
| 10 | Manschette |
| 12 | lange Grundseite |
| 14 | Druckknopf — Kopfteil |
| 16 | Druckknopf — Buchsenteil |
| 18 | Trägermaterial |
| 20 | Metallfolie |
| 22 | äußeres Halbteil |
| 24 | inneres Halbteil |
| 26 | Teller |
| 28 | Rand |
| 30 | Stift |
| 32 | Stufe |
| 34 | Teller |
| 36 | Steckbuchse |
| 38, 40 | Axialbohrung |
| 42 | Loch |
| 44, 46 | Massebandabschnitt |
| 48, 50, 52 | Befestigungselement |
| 54, 56 | Lage Trägermaterial |
| 58 | Einlage |
| 60 | Naht |
| 62 | kurzer Streifen Trägermaterial |
| 64 | kurzer Streifen Metallfolie |
| 66 | langer Streifen Trägermaterial |
| 68 | Ende Metallfolie |

**Patentansprüche**

1. Entstörabschirmung für Zündverteiler an Brennkraftmaschinen, bestehend aus einer biegsamen, elektrisch leitenden Manschette (10) mit wenigstens einer Lage Trägermaterial (18, 54, 56), die faltbar ist und deren seitliche Randflächen Verbindungsteile (14, 16) aufweisen und durch diese lösbar miteinander verbindbar sind, wobei im montierten Zustand die seitlichen Randflächen aneinanderliegen und die Manschette den Zündverteiler und seine Leitungen im Mündungsbereich umschließt, dadurch gekennzeichnet, daß das Trägermaterial (18, 54, 56) der Manschette (10) elektrisch nicht leitfähig ist und aus Gewebe, Kunststoffolie oder dergleichen besteht, daß an der Lage bzw. zwischen den Lagen Trägermaterial (18, 54, 56) eine separate elektrisch leitfähige Auflage (20) oder Einlage (58) fixiert ist, und daß das Trägermaterial und die Auflage bzw. Einlage punktweise mit Befestigungselementen (22, 24) zusammengespannt sind, die zugleich ein Verbindungsteil (14, 16) der lösbaren Manschettenrandverbindung tragen.

2. Entstörabschirmung nach Anspruch 1, dadurch gekennzeichnet, daß bei einem zweischichtigen Aufbau der Manschette (10) aus einer Lage Trägermaterial (18) mit einer elektrisch leitfähigen Auflage (20) oder Beschichtung das Trägermaterial (18) im gefalteten Zustand der Manschette (10) außen liegt.

3. Entstörabschirmung nach Anspruch 1, dadurch gekennzeichnet, daß die Manschette (10) dreischichtig aus zwei Lagen Trägermaterial (54, 56) und einer dazwischenliegenden, elektrisch leitfähigen Einlage (58) oder Beschichtung aufgebaut ist.

4. Entstörabschirmung nach Anspruch 3, dadurch gekennzeichnet, daß die Lagen Trägermaterial (54, 56) am Rand dauerhaft miteinander verbunden, insbesondere vernäht (Naht 60) oder verklebt sind.

5. Entstörabschirmung nach einem der vorhergehenden Ansprüche, dadurch gekennzeichnet, daß als Manschettenrandverbindung eine Druckknopfanordnung vorgesehen ist, und daß die von den Befestigungselementen (22, 24) getragenen Verbindungsteile durch den Kopf (14) und die zugehörige Aufnahmebuchse (16) der Druckknopfanordnung gebildet sind.

6. Entstörabschirmung nach einem der vorhergehenden Ansprüche, dadurch gekennzeichnet, daß die Befestigungselemente aus zwei Halbteilen (22, 24) aufgebaut sind, die je einen tellerförmigen Anlageabschnitt (26, 34) aufweisen und mittels eines die Manschette (10) durchstoßenden Schaftes (30) miteinander verrastbar sind.

7. Entstörabschirmung nach Anspruch 6, dadurch gekennzeichnet, daß der Schaft (30) an dem Anlageabschnitt (26) des einen Halbteils (22) angeordnet und in eine mit dem anderen Halbteil (24) verbundene Steckbuchse (36) eingreift.

8. Entstörabschirmung nach einem der vorhergehenden Ansprüche, dadurch gekennzeichnet, daß die Befestigungselemente (22, 24) aus Kunststoff bestehen.

9. Entstörabschirmung nach einem der vorhergehenden Ansprüche, dadurch gekennzeichnet, daß die elektrisch leitfähige Auflage (20), Einlage (58) oder Beschichtung eine Metallfolie insbesondere aus Aluminium, Zinn, Kupfer oder eine Legierung dieser Metalle mit oder ohne Oberflächenschicht aus Silber ist.

10. Entstörabschirmung nach einem der vorhergehenden Ansprüche, dadurch gekennzeichnet, daß die Manschette (10) mit einem Masseband (44, 46) versehen ist, das mit der elektrisch leitenden Auflage (20), Einlage (58) oder Beschichtung in Berührung steht und mittels eines Befestigungselements (48) an der Manschette (10) anbringbar ist.

11. Entstörabschirmung nach Anspruch 9, dadurch gekennzeichnet, daß das Masseband (44, 46) mit eine Druckknopfanordnung bildenden Befestigungselementen (50, 52) belegt und mittels dieser Druckknopfanordnung zu einem Ring schließbar ist.

12. Entstörabschirmung nach einem der vorhergehenden Ansprüche, dadurch gekennzeichnet, daß das Masseband (44, 46) aus einem elektrisch leitenden Kunststoff oder elektrisch leitenden Elastomer, beispielsweise einem Silikonelastomer, besteht.

13. Entstörabschirmung nach einem der Ansprüche 1 bis 11, dadurch gekennzeichnet, daß das Masseband aus eienem Streifen Trägermaterial (62, 66) mit einer elektrisch leitfähigen Auflage (64, 68) oder Beschichtung besteht.

14. Entstörabschirmung nach Anspruch 13, dadurch gekennzeichnet, daß die Auflage (68) punktweise mit dem Trägermaterial (66) verbunden ist, vorzugsweise mit einem Befestigungselement (50) an nur einem einzigen Punkt.

15. Entstörabschirmung Anspruch 13 oder 14, dadurch gekennzeichnet, daß sich die Auflage (68) nur über einen Teil der Länge des Streifens Trägermaterial (66) erstreckt.

16. Entstörabschirmung nach einem der Ansprüche 12 bis 15, dadurch gekennzeichnet, daß das Masseband (44, 46; Anspruch 12) bzw. der Streifen Trägermaterial (66; Ansprüche 13 bis 15) elastisch ist.

**Revendications**

1. Ecran d'antiparasitage pour allumeurs de moteurs à combustion interne, composé d'une manchette (10) électroconductrice flexible qui comprend au moins une couche de matériau-support (18, 54, 56), qui est pliable et dont les surfaces marginales latérales présentent des pièces d'assemblage (14, 16) et peuvent être assemblées entre elles par ces dernières, les surfaces marginales latérales étant appliquées l'une contre l'autre en position de montage et la manchette entourant l'allumeur et ses câbles dans la zone d'ouverture, caractérisé en ce que le matériau-support (18, 54, 56) de la manchette (10) n'est pas électroconducteur et est composé de tissu, d'une feuille de matière plastique ou analogue, en ce qu'une couche électroconductrice séparée de recouvrement (20) ou intercalaire (58) est fixée sur la couche ou entre les couches de matériau-support (18, 54, 56) et en ce que le matériau-support et la couche électroconductrice sont assemblés par points avec des éléments de fixation (22, 24) qui portent en même temps une pièce d'assemblage (14, 16) de l'assemblage marginal amovible de la manchette.

2. Ecran d'antiparasitage selon la revendication 1, caractérisé en ce que dans le cas où la manchette (10) présente une structure à deux couches composée d'une couche de matériau-support (18) avec une couche électroconductrice de recouvrement (20), le matériau-support (18) se trouve à l'extérieur lorsque la manchette (10) est pliée.

3. Ecran d'antiparasitage selon la revendication 1, caractérisé en ce que la manchette (10) est composée de trois couches, à savoir deux couches de matériau-support (54, 56) et une couche intercalaire électroconductrice (58).

4. Ecran d'antiparasitage selon la revendication 3, caractérisé en ce que les couches de matériau-support (54, 56) sont reliées entre elles durablement sur le bord, et sont en particulier cousues (couture 60) ou collées.

5. Ecran d'antiparasitage selon l'une des revendications précédentes, caractérisé en ce que l'assemblage marginal de la manchette est constitué par un dispositif à boutons-pressions et en ce que les pièces d'assemblage portées par les éléments de fixation (22, 24) sont formées par la tête (4) et la douille de réception correspondante (16) du dispositif à boutons-pressions.

6. Ecran d'antiparasitage selon l'une des revendications précédentes, caractérisé en ce que les éléments de fixation sont composés de deux demi-pièces (22, 24) qui présentent chacune une partie d'appui (26, 34) en forme de plateau et peuvent être verrouillées l'une avec l'autre à l'aide d'une tige (30) traversant la manchette (10).

7. Ecran d'antiparasitage selon la revendication 6, caractérisé en ce que la tige (30) est disposée sur la partie d'appui (26) de l'une des demi-parties (22) et s'engage dans une douille d'enfichage (36) reliée à l'autre demi-partie (24).

8. Ecran d'antiparasitage selon la revendication 6, caractérisé en ce que les éléments de fixation (22, 24) sont en matière plastique.

9. Ecran d'antiparasitage selon l'une des revendications précédentes, caractérisé en ce que la couche électroconductrice de recouvrement (20) ou intercalaire (58) est une feuille de métal, en particulier en aluminium, en étain, en cuivre ou en un alliage de ces métaux, avec ou sans couche superficielle en argent.

10. Ecran d'antiparasitage selon l'une des revendications précédentes, caractérisé en ce que la manchette (10) est munie d'une bande de mise à la masse (44, 46) qui est en contact avec la couche électroconductrice de recouvrement (20) ou intercalaire (58) et peut être fixée sur la manchette (10) à l'aide d'un élément de fixation (48).

11. Ecran d'antiparasitage selon la revendication 9, caractérisé en ce que la bande de mise à la masse (44, 46) est équipée d'éléments de fixation (50, 52) formant un dispositif à boutons-pressions et peut être fermée à l'aide de ce dispositif à boutons-pressions pour former un anneau.

12. Ecran d'antiparasitage selon l'une des revendications précédentes, caractérisé en ce que la bande de mise à la masse (44, 46) est composée d'une matière plastique électroconductrice ou d'un élastomère électroconducteur, par exemple d'un élastomère de silicone.

13. Ecran d'antiparasitage selon l'une des revendications 1 à 11, caractérisé en ce que la bande de mise à la masse est composée d'un ruban de matériau-support (62, 66) avec une couche électroconductrice de recouvrement (64, 68).

14. Ecran d'antiparasitage selon la revendication 13, caractérisé en ce que la couche de recouvrement (68) est reliée par points au matériau-support (66), de préférence par un élément de fixation (50) en un seul point.

15. Ecran d'antiparasitage selon la revendication 13 ou 14, caractérisé en ce que la couche de recouvrement (68) s'étend uniquement sur une partie de la longueur du ruban de matériau-support (66).

16. Ecran d'antiparasitage selon l'une des revendications 12 à 15, caractérisé en ce que la bande de mise à la masse (44, 46; revendication 12) ou le ruban de matériau-support (66; revendications 13 à 15) est élastique.

## Claims

1. Interference suppressor for distributors in internal combustion engines, comprising a flexible electrically conductive sleeve (10) with at least one layer of carrier material (18, 54, 56) which is foldable and whose lateral edge surfaces have connecting parts (18, 16) through which they are releasably connected with each other, whereby in the assembled state the lateral edge surfaces lie next to each other and the sleeve encloses the distributor and its conductors in the outlet area, characterised in that the carrier material (18, 54, 56) of the sleeve (10) is electrically non-conductive and consists of fabric, plastic foil or the like, that on the layer or between the layers of carrier material (18, 54, 56) there is fixed a separate electrically conductive overlay (20) or intermediate layer (58), and that the carrier material and the layer or intermediate layer are fixed together under tension along points by means of fixing elements (22, 24) which at the same time carry a connecting part (14, 16) of the releasable sleeve edge connection.

2. Interference suppressor according to claim 1, characterised in that the case of twin-layer construction of the sleeve (10) comprising a layer of carrier material (18) with an electrically conductive overlay (20) or coating of the carrier material (18), in the folded condition of the sleeve (10) the carrier material is on the outside.

3. Interference suppressor according to claim 1, characterised in that the sleeve (10) consists of three layers, made up of two layers of carrier material (54, 56) and an electrically conductive insert (58) or coating arranged in between.

4. Interference suppressor according to claim 3, characterised in that the layers of carrier material (54, 56) are permanently connected with each other at the edge, especially sewn (seam 60) or glued.

5. Interference suppressor according to one of the aforementioned claims, characterised in that a press-stud arrangement is used as the sleeve edge connection and that the connecting parts carried by the fastening elements (22, 24) are formed by the head (14) and the associated receiving shell (16) of the press stud arrangement.

6. Interference suppressor according to one of the aforementioned claims, characterised in that the securing elements are made up of two half portions (22, 24) each having a plate-like hub section (26, 34) and which can be locked together by means of a shaft (30) penetrating the sleeve (10).

7. Interference suppressor according to claim 6, characterised in that the shaft (30) is arranged on the hub section (26) of the half portion (22) and engages in a plug-in sleeve (36) connected with the other half portion (24).

8. Interference suppressor according to one of the aforementioned claims, characterised in that the fastening elements (22, 24) are made of plastics.

9. Interference suppressor according to one of the aforementioned claims, characterised in that the electrically conductive layer (20), insert (58) or coating is a metal foil, especially of aluminium, zinc, copper or an alloy of these metals with or without a surface coating of silver.

10. Interference suppressor according to one of the aforementioned claims, characterised in that the sleeve (10) is provided with an earth strip (44, 46) which is in contact with the electrically conductive layer (20), insert (58) or coating and which can be attached to the sleeve (10) by means of a securing element (48).

11. Interference suppressor according to claim 9, characterised in that the earth strip (44, 46) is covered with fastening elements (50, 52) forming a press-stud arrangement and through this press-stud arrangement can be closed to form a ring.

12. Interference suppressor according to one of the aforementioned claims, characterised in that the earth strip (44, 46) consists of an electrically conductive plastics or an electrically conductive elastomer, for example a silicone elastomer.

13. Interference suppressor according to one of the claims 1 to 11, characterised in that the earth strip consists of a strip of carrier material (62, 66) with an electrically conductive layer (64, 68) or a coating.

14. Interference suppressor according to claim 13, characterised in that the layer (68) is connected point-by-point with the carrier material (66), preferably at one point only, by means of a fastening element (50).

15. Interference suppressor according to claim 13 or 14, characterised in that the layer (68) extends only over one part of the length of the strip of carrier material (66).

16. Interference suppressor according to one of the claims 12 to 15, characterised in that the earth strip (44, 46; claim 12) or the strip of carrier material (66; claims 13 to 15) is elastic.

FIG. 1

# FIG. 2

FIG. 3

FIG. 4